# EUROPEAN PATENT SPECIFICATION

(11) **EP 0 401 908 B1**
(45) Date of publication and mention of the grant of the patent: **15.05.1996**
(21) Application number: 90201397.8
(22) Date of filing: 01.06.1990
(51) Int. Cl.: G01R 33/56

(54) **Magnetic resonance method and device for acquiring short echo time images**
Verfahren und Vorrichtung zur Bilderzeugung in kurzer Echo-Zeit mittels magnetischer Resonanz
Procédé et appareil d'acquisition d'images à bref temps d'echo par résonance magnétique

(30) Priority: 07.06.1989 EP 89201458
(43) Date of publication of application: 12.12.1990
(73) Proprietor: Philips Electronics N.V., 5621 BA Eindhoven (NL)
(72) Inventor: Scheidegger, Markus, NL-5656 AA Eindhoven (NL); Bösiger, Peter, NL-5656 AA Eindhoven (NL)
(74) Representative: Schouten, Marcus Maria

(56) References cited:
- EP-A- 0 218 726
- EP-A- 0 222 325
- EP-A- 0 223 543
- EP-A- 0 280 310
- EP-A- 0 316 041
- GB-A- 2 201 794
- US-A- 4 791 369

## Description

The invention relates to a magnetic resonance imaging method, in which an object is situated in a stationary homogeneous magnetic field and is subjected to an acquisition sequence for acquiring a magnetic resonance signal from a region of the object, the acquisition sequence comprising an rf-pulse for exciting atomic spins in the object, a phase encoding gradient, and a reading gradient which is reversed for acquiring the magnetic resonance signal, the acquisition sequence being repeated a number of times with a different value of the time integral of the phase encoding gradient.

The invention also relates to a magnetic resonance device comprising means for generating a stationary homogeneous magnetic field, means for exciting rf-pulses, means for generating magnetic field gradients, means for detecting and sampling magnetic resonance signals obtained with the aforementioned means in an object which is situated in the homogeneous field, control means for controlling said means for exciting rf-pulses, said means for generating magnetic field gradients and said means for detecting and sampling, image reconstruction means, and programmed means programmed such that an acquisition sequence for acquiring a gradient recalled echo with a reading gradient is applied to the object by means of said means for exciting rf-pulses, said means for generating magnetic field gradients, said means for detecting and sampling and said control means.

A method and device of this kind are known from the Handbook, "Practical NMR Imaging", M.A. Foster and J.M.S. Hutchinson, 1987, IRL Press, pp. 15-22, and pp. 28-38. A Fourier transform sequence is given at page 19 and a blockdiagram of an NMR imaging device is shown at page 29 of said Handbook. In the method the body is irradiated with an rf-pulse, e.g. a 90^{o} pulse, in the presence of a slice selection gradient, thus flipping atomic spins, such as nuclear spins or with adaptations electron spins, of a slice of the body in a rotating frame rotating with the Larmorfrequency by an angle of 90°, resulting in an FID-signal (free induction decay). Then the FID is succesively dephased by a reading gradient having a first polarity and rephased by reversing the reading gradient. During rephasing a socalled gradient recalled echo occurs. Twodimensional coding is achieved by applying a variable amplitude phase encoding gradient and by sampling the echo signal. Fourier reconstruction gives a spatially resolved spin distribution of the slice that can be displayed on a monitor as a greyscale image e.g. Extension to 3D-imaging is wellknown and straightforward, so is a modification of the sequence to a socalled projection reconstruction sequence. In the sequence the maximum of the echo occurs at a point of time tₑ from the centre of the pulse at tₒ. The time difference tₑ- tₒ is the socalled echo time, which may not be chosen too small in case a complete echo is to be sampled. A too small echo time causes echo distortion and eventually image artefacts. In case short echo times are desired, e.g. for Sodium-imaging, for less flowartefacts, or for getting a different image contast, a distorted echo could only be sampled right to the echo maximum or so (asymmetric sampling). Ideally the image would be real, and displaying the real part of the image would suffice. But due to inter alia B₀-inhomogeneities, susceptibility, eddy currents and flow, the image is not real. Thus, direct real-part reconstruction or, equivalently, data mirroring in k-space often leads to inacceptable image artefacts. Correction methods are known for correcting some of these problems e.g. from the European Patent Application No. 0 250 050, giving an iterative correction algorithm. This algorithm needs more than half of the k-space (e.g. 5/8-th of an echo is sampled), thus restricting echo time reduction. Such correction methods tend to be artefact-sensitive if 50% of the data in k-space is missing, or if the phase varies rapidly over the image in the case of blood flow e.g. Then it would be expedient to acquire data over the whole k-space.

It is an object of the invention to provide an NMR-imaging method having short echo times and not leading to unacceptable artefacts due to rapid phase variations e.g.

To this end a method according to the invention is characterized in that the object is subjected to further acquisition sequences differing from said acquisition sequences in having a reading gradient of opposite polarity to said reading gradient, in that the magnetic resonance signals from the acquisition sequences and the further acquisition sequences are sampled starting sampling at least approximately from maxima of the resonance signals giving a first and a second set of half-echo samples, in that the half-echo samples from the first and second set corresponding to the same value of said time integral are combined to form a reconstructed full echo, and in that an image is reconstructed from the reconstructed full echoes. Very short echo times without disturbing flowartefacts have been obtained, e.g. in a 1.5 T system between 3 and 4.5 msec with usual imaging parameters. Samples in the centre of the k-space are measured twice and an average is formed when combining "halfechoes" to full "pseudo-echoes". As the two readout gradients have opposite signs, so do the flow-induced phase shifts caused by movements in the readout direction. For the k-space-centre samples, artefacts are therefore cancelled ruing reconstruction. This effect is enhanced by the low sensitivity to flow-induced phase shifts of a short T_{E} sequence.

An embodiment of a method according to the invention is characterized in that before forming a reconstructed full echo a first and a second sampling shift are applied to the half-echo samples of the first and second set respectively, the first and second sampling shift being obtained from samples from resonance signals acquired with a given value of said time integral by determining shifts of respective first samples to signal maxima. It is thus achieved that unacceptable misalignment of half-echoes is corrected before combining the half-echoes to a reconstructed, complete, echo. The sampling shifts are determined for a zero phase encoding e.g. and may appear to be two or three sampling intervals in practice. For other phase encoding steps the determined sampling shifts are applied before combining half-echoes.

The features and advantages of the method and device according to the invention will be more clearly apparent from the following detailed description, in conjunction with the accompanying drawing, wherein
Fig. 1 shows, diagrammatically, a magnetic resonance device according to the invention,
Fig. 2 shows a pulse sequence according to the invention,
Fig. 3A, 3B and 3C show combination of half echoes to a reconstructed echo in detail, and
Fig. 4 shows phase shifts induced by flowing spins in readout direction.

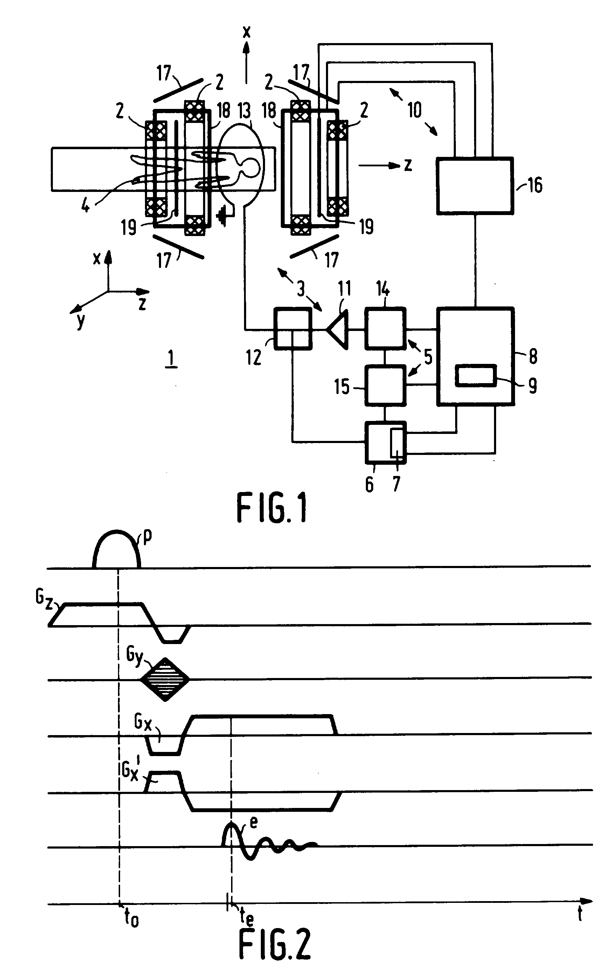

In Fig. 1 there is shown, diagrammatically, a magnetic resonance device 1 according to the invention comprising means 2 for generating a stationary homogeneous magnetic field B₀, means 3 for exciting rf-pulses to be irradiated to an object 4, modulating means 5 for modulating the rf-pulses, detecting means 6 for detecting excited magnetic resonance signals, sampling means 7 for sampling the magnetic resonance signals and control means 8 for controlling said means 3, 5, 6 and 7. The device 1 further comprises Fourier transform (or filtered back-projection) means 9 for reconstructing an image from the sampled magnetic resonance signals, means 10 for generating magnetic field gradients which are superimposed upon the stationary magnetic field. In further detail the means 3 comprise the means 5, a power amplifier 11, a directional coupler 12 and a coil 13. The means 5 comprise a modulator 14 and an oscillator 15. The means 3 will excite nuclear spins in the object 4 when transmitting rf-pulses and the means 6 will receive magnetic resonance signals in response thereupon. The demodulating means comprise a quadrature demodulator and the sampling means 7 two A/D-converters giving quadrature detected samples of respective sin and cos components of the magnetic resonance signal. The means 10 comprise a power supply 16 to be controlled by the control means 8, for separately controlling gradient magnet coils 17, 18 and 19 for respective generation of magnetic field gradients Gₓ, G_{y} and G_{z}. The gradient magnet coils may be arranged such that the field direction of the magnetic field gradient coincides with the direction of the stationary homogeneous magnetic field and that the directions of the gradients are mutually perpendicular, indicated with mutually perpendicular axes x, y and z. If the device 1 is put into operation and the object 4 is placed inside the magnet coils 2 a small excess of nuclear spins (of nuclei having a magnetic moment) will be directed into the direction of the stationary homogeneous magnetic field, which can be considered macroscopically as a magnetization M, an equilibrium magnetization. For a more detailed description of an MRI device and a general description of the principles of MRI referred is to said Handbook, "Practical NMR Imaging".

In Fig. 2 there is shown a pulse sequence according to the invention as a function of time t. At the instant t=t₀ an rf-pulse p is excited with said means 3 and irradiated to the object 4. For selecting a part of the object 4 (a slice perpendicular to the z-axis e.g.) a selection gradient G_{z} is applied during the rf-pulse p by means of the gradient magnet coil 19. The rf-pulse p selectively rotates a magnetization (90^{o} or less). A magnetization in the xy-plane (transverse magnetization) gives an FID-signal (not shown). A phase encoding gradient G_{y} is applied after the rf-pulse p by means of the gradient magnet coil 18 for phase encoding nuclear spins in the part of the object. During the gradient G_{y} also a reading gradient Gₓ is applied by means of the gradient coil 17 for dephasing the spins. Thereafter the reading gradient Gₓ is reversed giving a recalled FID at the instant t=tₑ, an echo e. The echo e is quadrature detected and sampled by means of two A/D converters, so that real and imaginary signal components are acquired. The acquisition sequence is repeated for different values of the time integral of the phase encoding gradient G_{y}. The samples are stored, building up a first set of samples. A further acquisition sequence is applied being identical to the described sequence but for the gradient Gₓ. A gradient Gₓ' therein is opposite to the gradient Gₓ. The samples acquired with the further acquisition sequence are stored and build up a second set of samples. Samples from the first and second set are combined to form a reconstructed echo. By means of the Fourier transform means 9 a two dimensional Fourier transform is carried out on the combined sets for getting a spin-density distribution. The spin-density distribution is displayed as a greyscale image e.g. on a monitor (not shown).

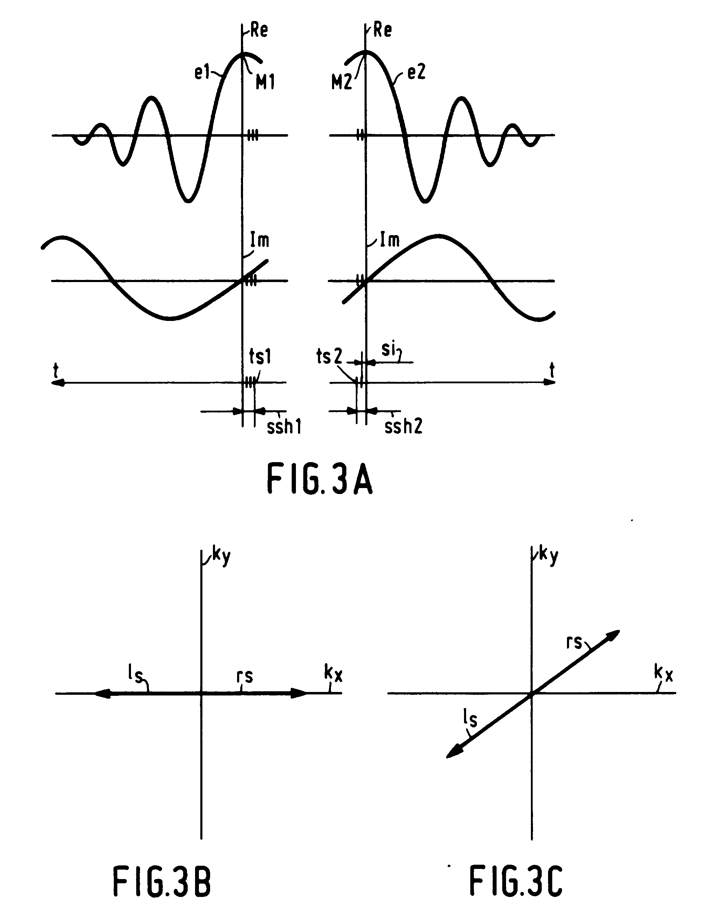

In Fig. 3A, 3B and 3C combination of half-echoes to a reconstructed echo is shown in detail. Fig. 3A shows real Re and imaginary Im parts of half-echoes e1 and e2 acquired with said acquisition sequences as a function of time t. Before combining the half-echoes e1 and e2 to a reconstructed echo a first and a second sampling shift ssh1 and ssh2 are determined with respect to actual first samples ts1 and ts2. The sampling shifts ssh1 and ssh2 are determined from maximum moduli of samples around the signal maxima M1 and M2 respectively. Typically the sampling shifts ssh1 and ssh2 are in the order of 2-3 sampling intervals si. The sampling shifts ssh1 and ssh2, determined for a zero phase encoding e.g., are applied for all other phase encoding steps. The first order phase correction prior to concatenating the half-echoes (FID-acquired-echoes) to a reconstructed echo ensures that symmetric reconstructed echoes are obtained, otherwise artefacts for lower spatial frequencies would occur. In fig. 3B wherein k-space (kₓk_{y}) is shown it is achieved that k-space is scanned symmetrically, shown for G_{y}=0 for a right scan rs and a left scan ls. In practical situations omitting phase correction would cause asymmetrical k-space scanning. In Fig. 3C a simular situation is shown when applying projection reconstruction sequences. With the method according to the invention very short echo times can be achieved. It should be noted that were there no phase errors (which does not hold in practice, generally) short echo times could also be achieved from right half k-space data e.g., but the modulus reconstruction could not be applied. Phase errors would lead to unacceptable image artefacts in practical situations when using only right half k-space data. The method according to the invention has been implemented on a whole body 1.5 T system. For a field of view of 250 mm, a 256x256 pixel matrix (giving a 1 mm image resolution), and a slice thickness of 5 mm, in a 2D-FT or 3DFT fast imaging sequence echo times between 3.0 and 4.5 msec were obtained. For small sequence repetition times (e.g. <100 msec) an opposite G_{y} gradient and for spurious FID suppression a constant dephasing gradient Gₓ (repetition times <200 msec) were applied after signal sampling. E.g. images have been made of a human head using headcoils or heart images using a whole body coil. In a multiple slice version together with gating and a sequence repetition time of 30 msec a heart movie was made with an image frequency of 32 images per second for the same slice. Flow images can be made when displaying a phase image instead of a modulus image. It should be noted that the order of acquisition of the signals for the first and second set can be chosen freely but it is advantageous to acquire signals with opposite reading gradients for the same value of the time integral of the phase encoding gradient consecutively. It should further be noted that the acquisition sequences may be modified, the invention being applicable to many variants of the described sequence, so the sequences may constitute a multiple-echo sequence e.g.

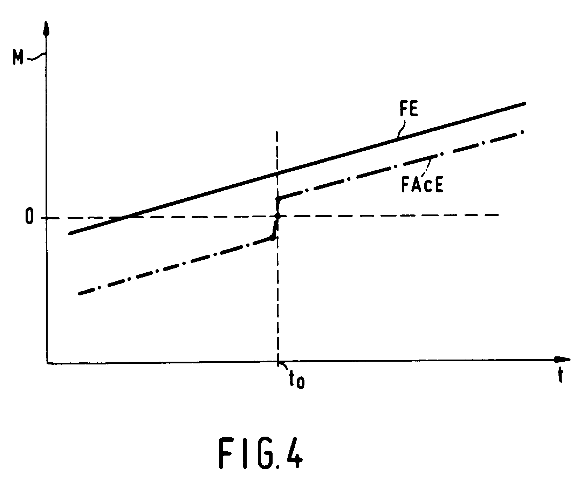

Fig. 4 shows phase shifts induced by flowing spins in readout direction for conventional sequences such as fast imaging (FE) and according to present invention (FAcE) as a function of time t with respect to M=0 of the first moment M of the readout gradient during the sampling period and with respect to the echo maximum at t=t₀. As in present invention the two readout gradients have opposite signs, so do the flow-induced phase shifts caused by movements in the readout direction. For the k-space-centre samples, artefacts are therefore cancelled during reconstruction. Experiments with flow compensated fast image sequences and sequences according to present invention show superior artefact suppression of present invention. Due to this high flow-artefact suppression, in vivo images display very fine branching vessels in the brain, and also lung vessels.

## Claims

1. Magnetic resonance imaging method, in which an object (4) is situated in a stationary homogeneous magnetic field and is subjected to an acquisition sequence for acquiring a magnetic resonance signal (e) from a region of the object, the acquisition sequence comprising an rf-pulse (p) for exciting atomic spins in the object, a phase encoding gradient (G_{y}), and a reading gradient (Gₓ) which is reversed for acquiring the magnetic resonance signal (e), the acquisition sequence being repeated a number of times with a different value of the time integral of the phase encoding gradient (G_{y}), characterized in that the object is subjected to further acquisition sequences differing from said acquisition sequences in having a reading gradient (Gₓ') of opposite polarity to said reading gradient (Gₓ), in that the magnetic resonance signals (e) from the acquisition sequences and the further acquisition sequences are sampled starting sampling at least approximately from maxima of the resonance signals giving a first and a second set of half-echo samples (e1,e2), in that the half-echo samples (e1,e2) of the first and second set corresponding to the same value of said time integral are combined to form a reconstructed full echo, and in that an image is reconstructed from the reconstructed full echoes.

2. Magnetic resonance imaging method according to claim 1, characterized in that before forming a reconstructed full echo a first and a second sampling shift (ssh1,ssh2) are applied to the half-echo samples (e1,e2) of the first and the second set respectively, the first and the second sampling shift (ssh1,ssh2) being obtained from samples from resonance signals acquired with a given value of said time integral by determining shifts of respective first samples to signal maxima.

3. Magnetic resonance imaging method according to claim 2, characterized in that the shifts (ssh1, ssh2) to maxima are determined from moduli of samples around the maxima.

4. Magnetic resonance imaging method according to claim 1,2 or 3, characterized in that the image is reconstructed as a modulus image.

5. Magnetic resonance imaging method according to Claim 1, 2, 3 or 4, characterized in that said acquisition sequences are modified to projection reconstruction sequences.

6. Magnetic resonance imaging method according to one of the preceding Claims used for flow imaging, especially for flow in the direction of the reading gradient.

7. Magnetic resonance device (1) comprising means (2) for generating a stationary homogeneous magnetic field, means (3) for exciting rf-pulses, means (10) for generating magnetic field gradients, means (6, 7) for detecting and sampling magnetic resonance signals obtained with the aforementioned means in an object (4) which is situated in the homogeneous field, control means (8) for controlling said means (3) for exciting rf-pulses, said means (10) for generating magnetic field gradients and said means (6, 7) for detecting and sampling, image reconstruction means (9), and programmed means programmed such that an acquisition sequence for acquiring a gradient recalled echo with a reading gradient is applied to the object (4) by means of said means (3) for exciting rf-pulses, said means (10) for generating magnetic field gradients, said means (6, 7) for detecting and sampling and said control means (8), characterized in that the device comprises further programmed means programmed such that a further acquisition sequence for acquiring a further gradient recalled echo with a reading gradient of opposite polarity to said reading gradient is applied to the object, that half-echo samples (e1,e2) at least approximately starting from maxima of the resonance signals of the respective sequences are obtained, that sampling shifts (ssh1,ssh2) are applied to the half-echo samples (e1,e2), that the half-echo samples (e1,e2) are combined to a reconstructed full echo, and that an image is reconstructed from the reconstructed full echoes.

## Patentansprüche

1. Kernspinresonanzabbildungsverfahren, mit dem ein Objekt (4) sich in einem statischen homogenen Magnetfeld befindet und einer Erfassungssequenz zum Erfassen eines Kernspinresonanzsignals (e) aus einem Gebiet des Objekts unterworfen wird, wobei die Erfassungssequenz einen Hf-Impuls (p) zum Erregen von Atomspins im Objekt, einen Phasencodiergradienten (G_{y}) und einen Lesegradienten (Gₓ) enthält, der zum Erfassen des Kernspinresonanzsignals (e) umgekehrt wird, die Erfassungssequenz einige Male mit einem anderen Wert des Zeitintegrals des Phasencodiergradienten (G_{y}) wiederholt wird, dadurch gekennzeichnet, daß das Objekt weiteren Erfassungssequenzen abweichend von den Erfassungssequenzen durch einen Lesegradienten (Gₓ') mit entgegengesetzter Polarität zum Lesegradienten (Gₓ) unterworfen wird, daß die Kernspinresonanzsignale (e) aus den Erfassungssequenzen und den weiteren Erfassungssequenzen ausgehend vom Abtasten wenigstens etwa von Höchstwerten der Resonanzsignale mit einer ersten und einer zweiten Gruppe von Halbechoabtastungen (e1, e2) abgetastet werden, daß die Halbechoabtastungen (e1, e2) der ersten und der zweiten Gruppe entsprechend demselben Wert des Zeitintegrals zur Bildung eines rekonstruierten Ganzechos kombiniert werden, und daß ein Bild aus den rekonstruierten Ganzechos rekonstruiert wird.

2. Kernspinresonanzabbildungsverfahren nach Anspruch 1, dadurch gekennzeichnet, daß vor der Bildung eines rekonstruierten Ganzechos eine erste und eine zweite Abtastverschiebung (ssh1, ssh2) an die Halbechoabtastungen (e1, e2) der ersten und bzw. der zweiten Gruppe gelegt werden, wobei die erste und die zweite Abtastverschiebung (ssh1, ssh2) aus Abtastungen von Resonanzsignalen erhalten werden, die mit einem vorgegebenen Wert des Zeitintegrals durch Bestimmung der Verschiebungen jeweiliger erster Abtastungen zu Signalhöchstwerten erfaßt werden.

3. Kernspinresonanzabbildungsverfahren nach Anspruch 2, dadurch gekennzeichnet, daß die Verschiebungen (ssh1, ssh2) zu Höchstwerten aus Moduln von Abtastungen um die Höchstwerte bestimmt werden.

4. Kernspinresonanzabbildungsverfahren nach Anspruch 1, 2 oder 3, dadurch gekennzeichnet, daß das Bild als Modulbild rekonstruiert wird.

5. Kernspinresonanzabbildungsverfahren nach Anspruch 1, 2, 3 oder 4, dadurch gekennzeichnet, daß die Erfassungssequenzen nach Projektionsrekonstruktionssequenzen geändert werden.

6. Kernspinresonanzabbildungsverfahren nach einem oder mehreren der vorangehenden Ansprüche zur Verwendung für Flußabbildung, insbesondere für Strömungen in der Richtung des Lesegradienten.

7. Kernspinresonanzanordnung (1) mit einem Mittel (2) zum Erzeugen eines statischen homogenen Magnetfelds, einem Mittel (3) zum Erregen von Hf-Impulsen, einem Mittel (10) zum Erzeugen von Magnetfeldgradienten, einem Mittel (6, 7) zum Detektieren und Abtasten von Kernspinresonanzsignalen, die mit dem erwähnten Mittel in einem Objekt (4) erhalten wurden, das sich im homogenen Feld befindet, einem Steuermittel (8) zum Steuern des Mittels (3) zum Erregen von Hf-Impulsen, des Mittels (10) zum Erzeugen von Magnetfeldgradienten und des Mittels (6, 7) zum Detektieren und Abtasten, einem Abbildungsrekonstruktionsmittel (9) und mit einem programmierten Mittel, das derart programmiert ist , daß eine Erfassungssequenz zum Erfassen eines Gradientenabrufechos mit einem Lesegradienten an das Objekt (4) mit dem Mittel (3) zum Erregen von Hf-Impulsen, des Mittels (10) zum Erzeugen von Magnetfeldgradienden, des Mittels (6, 7) zum Detektieren und Abtasten und des Steuermittels (8) angelegt wird, dadurch gekennzeichnet, daß die Anordnung ein weiteres programmiertes Mittel enthält, das derart programmiert ist, daß eine weitere Erfassungssequenz zum Erfassen eines weiteren Gradientenabrufechos mit einem Lesegradienten entgegengesetzter Polarität zum Lesegradienten an das Objekt gelegt wird, daß Halbechoabtastungen (e1, e2) wenigstens nahezu ausgehend von Höchstwerten der Resonanzsignale der jeweiligen Sequenzen erhalten werden, daß Abtastverschiebungen (ssh1, ssh2) an die Halbechoabtastungen (e1, e2) gelegt werden, daß die Halbechoabtastungen (e1, e2) zu einem rekonstruierten Ganzecho kombiniert werden, und daß eine Abbildung aus den rekonstruierten Ganzechos rekonstruiert wird.

## Revendications

1. Procédé d'imagerie par résonance magnétique, dans lequel un objet (4) est situé dans un champ magnétique homogène stationnaire et est soumis à une séquence d'acquisition pour acquérir un signal de résonance magnétique nucléaire (e) à partir d'une région de l'objet, la séquence d'acquisition comprenant une impulsion rf (p) pour exciter des spins atomiques dans l'objet, un gradient de codage de phase (G_{y}) et un gradient de lecture (Gₓ) qui est inversé pour acquérir le signal de résonance magnétique (e), la séquence d'acquisition étant répétée plusieurs fois avec une valeur différente de l'intégrale de temps du gradient de codage de phase (G_{y}), caractérisé en ce que l'objet est soumis à des séquences d'acquisition supplémentaires différant desdites séquences d'acquisition en ce qu'elles possèdent un gradient de lecture (Gₓ') de polarité opposée audit gradient de lecture (Gₓ), en ce que les signaux de résonance magnétique (e) des séquences d'acquisition et des séquences d'acquisition supplémentaires sont échantillonnés en commençant l'échantillonnage du moins approximativement à partir des maxima des signaux de résonance pour donner une première série et une deuxième série d'échantillons de demi-écho (e1, e2), en ce que les échantillons de demi-écho (e1, e2) des première et deuxième séries correspondant à la même valeur de ladite intégrale de temps sont combinés pour former un écho complet reconstruit, et en ce qu'une image est reconstruite à partir des échos complets reconstruits.

2. Procédé d'imagerie par résonance magnétique selon la revendication 1, caractérisé en ce qu'avant de former un écho complet reconstruit, un premier et un deuxième décalage d'échantillonnage (ssh1, ssh2) sont appliqués aux échantillons de demi-écho (e1, e2) des première et deuxième séries respectivement, les premier et deuxième décalages d'échantillonnage (ssh1, ssh2) étant obtenus à partir d'échantillons de signaux de résonance acquis à une valeur donnée de ladite intégrale de temps en déterminant les décalages des premiers échantillons respectifs par rapport aux maxima de signal.

3. Procédé d'imagerie par résonance magnétique selon la revendication 2, caractérisé en ce que les décalages (ssh1, ssh2) par rapport aux maxima sont déterminés à partir de modules d'échantillons autour des maxima.

4. Procédé d'imagerie par résonance magnétique selon l'une des revendications 1, 2 ou 3, caractérisé en ce que l'image est reconstruite comme une image de module.

5. Procédé d'imagerie par résonance magnétique selon l'une des revendications 1, 2, 3 ou 4, caractérisé en ce que lesdites séquences d'acquisition sont modifiées en séquences de reconstruction par projection.

6. Procédé d'imagerie par résonance magnétique selon l'une quelconque des revendications précédentes, utilisé pour l'imagerie de flux, en particulier pour des flux en direction du gradient de lecture.

7. Dispositif de résonance magnétique (1) comprenant des moyens (2) pour générer un champ magnétique homogène stationnaire, des moyens (3) pour exciter des impulsions rf, des moyens (10) pour générer des gradients de champ magnétique, des moyens (6, 7) pour détecter et échantillonner des signaux de résonance magnétique obtenus à l'aide des moyens susmentionnés dans un objet (4) qui est situé dans le champ homogène, des moyens de commande (8) pour commander lesdits moyens (3) pour exciter des impulsions rf, lesdits moyens (10) pour générer des gradients de champ magnétique et lesdits moyens (6, 7) pour détecter et échantillonner, des moyens de reconstruction d'image (9) et des moyens programmés de telle sorte qu'une séquence d'acquisition pour acquérir un écho rappelé à gradient avec un gradient de lecture soit appliquée à l'objet (4) à l'aide desdits moyens (3) pour exciter des impulsions rf, desdits moyens (10) pour générer des gradients de champ magnétique, desdits moyens (6, 7) pour détecter et échantillonner et desdits moyens de commande (3), caractérisé en ce que le dispositif comprend des moyens programmés supplémentaires de telle sorte qu'une séquence d'acquisition supplémentaire pour acquérir un écho rappelé à gradient supplémentaire avec un gradient de lecture de polarité opposée audit gradient de lecture soit appliquée à l'objet, en ce que des échantillons de demi-écho (e1, e2) commençant approximativement du moins aux maxima des signaux de résonance des séquences respectives soient obtenus, en ce que des décalages d'échantillonnage (ssh1, ssh2) soient appliqués aux échantillons de demi-écho (e1, e2), en ce que les échantillons de demi-écho (e1, e2) soient combinés pour former un écho complet reconstruit, et en ce qu'une image soit reconstruite à partir des échos complets reconstruits.
